# EUROPEAN PATENT SPECIFICATION

(11) **EP 2 437 939 B1**
(45) Date of publication and mention of the grant of the patent: **28.09.2016**
(21) Application number: 10783673.6
(22) Date of filing: 02.06.2010
(51) Int. Cl.: B32B 33/00, B05D 5/00, B05D 7/00, H01L 23/28, H01L 33/56, H05B 33/04

(54) **MULTILAYER BARRIER FILM**
MEHRSCHICHTIGER BARRIERENFILM
FILM BARRIÈRE MULTICOUCHES

(30) Priority: 02.06.2009 US 183223 P
(43) Date of publication of application: 11.04.2012
(73) Proprietor: Agency for Science, Technology and Research, Singapore 138632 (SG)
(72) Inventor: RAMADAS, Senthil Kumar, Singapore 117602 (SG); CHUA, Soo Jin, Singapore 117602 (SG)
(74) Representative: Viering, Jentschura & Partner mbB Patent- und Rechtsanwälte
(86) International application number: PCT/SG2010/000204
(87) International publication number: WO 2010/140980

(56) References cited:
- WO-A1-2008/057045
- WO-A1-2009/126115
- WO-A1-2009/134211
- JP-A- 2003 276 110
- US-A1- 2008 138 538
- US-A1- 2009 015 757
- GUENTHER E. ET AL: 'Building blocks for ultrathin flexible organic electroluminescent devices' PROC. SPIE vol. 4464, 2002, pages 23 - 33, XP003026951

## Description

### CROSS-REFERENCE TO RELATED APPLICATIONS

The present application claims the benefit of priority of US provisional application No. 61/183,223, filed June 2, 2009, the content of which is hereby incorporated by reference in its entirety for all purposes.

### FIELD OF THE INVENTION

The present invention relates generally to the field of barrier films, and more particularly to optical graded barrier films.

### BACKGROUND OF THE INVENTION

Flexible Organic Light Emitting Diode (OLED) Displays are considered as a next generation display technology. These displays will provide new properties for displays including low weight, high impact resistance and mechanical flexibility. OLED display structures and other polymeric devices degrade in the presence of oxygen and moisture. It is estimated that for an OLED display to have a reliable performance with a lifetime exceeding 10,000 hours, the encapsulation structure around the active material should have an oxygen transmission rate (OTR) below 10⁻⁵ cc/m²/day and water vapor transmission rate (WVTR) of about 10⁻⁶ g/m²/day at 39°C and 95% RH.

Polymer films do not typically show high barrier performance (less than 10⁻⁵ to 10⁻⁶ cc/m²/day permeability of water vapor at 39°C and 95% RH) even if they are coated with a metal-oxide coating to improve their barrier properties.

US 2008/138538 A1 discloses a multilayer barrier film comprising a substrate layer coated on one side with a barrier layer, said barrier layer comprising a barrier coating and a repair coating disposed on the barrier coating. The repair coating comprises a metal based compound.

WO 2008/057045 A1 discloses a barrier stack for encapsulating a moisture and/or oxygen sensitive electronic device. The barrier stack comprises a multilayer film having at least one barrier layer having low moisture and/or oxygen permeability, and at least one sealing layer arranged to be in contact with a surface of the barrier layer, wherein the sealing material comprises reactive nanoparticles capable of interacting with moisture and/or oxygen, thereby retarding the permeation of moisture and/or oxygen through defects present in the barrier layer.

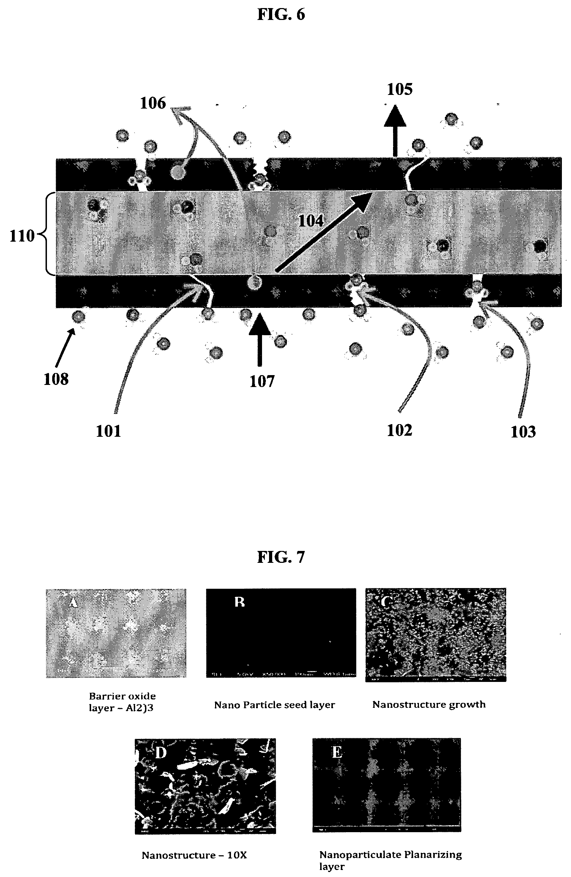

The integrity of deposited barrier layers, such as metal oxide coatings is a crucial factor in determining the overall gas barrier performance and the control of macro defects within the oxide layers is a critical requirement. Indeed, the performance of the barrier layers, such as metal-oxide-coated polymer films is a major technological hurdle towards a breakthrough in flexible organic light emitting displays. It is well known that polymer films 110 do not typically show high barrier performance even if they are coated with a metal oxide coating 106 to improve their barrier properties, as they suffer from imperfections such as pinholes 103, cracks 102, gaps occurring at grain boundaries 101 in the metal oxide layer. (see Figure 6).

It is therefore an object of the present invention to provide a high barrier substrate system with improved barrier properties.

### SUMMARY OF THE INVENTION

In a first aspect, the present invention is directed to a multilayer barrier film. The multilayer barrier film comprises:
▪ a substrate layer coated on one side with a barrier layer, wherein the barrier layer is made of a material selected from the group consisting of a metal oxide, a metal carbide, a metal nitride and a metal oxinitride;
▪ a nanostructured metal compound layer arranged on the barrier layer; and
▪ a planarising layer arranged on the nanostructured layer, wherein the planarising layer comprises a nanostructured material which is distributed in a polymeric binder, wherein the nanostructured material is made of a carbon, a metal or a metal oxide or a mixture of the aforementioned substances.

In a further aspect, the present invention is directed to a method of manufacturing a multilayer barrier film as described herein. The method can comprise:
▪ providing a barrier layer coated substrate;
▪ applying a solution of a metal particle precursor dissolved in an organic solvent on the barrier layer to obtain a seed layer;
▪ growing metal nanocrystals via a solvent thermal method to obtain a nanostructured metal compound layer;
▪ depositing a planarising layer on the nanostructured metal compound layer.

### BRIEF DESCRIPTION OF THE DRAWINGS

The invention will be better understood with reference to the detailed description when considered in conjunction with the non-limiting examples and the accompanying drawings.

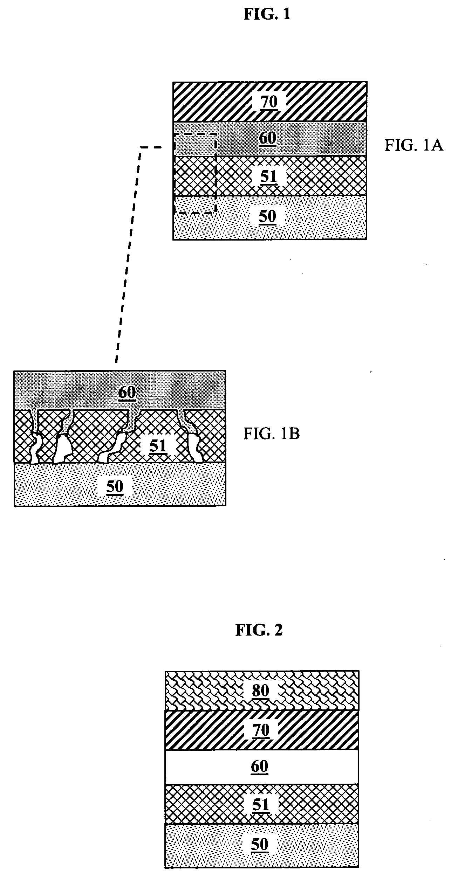

**Figure 1** shows the structure of a multilayer barrier film of an embodiment of the present invention. Figure 1a indicates the succession of layers forming the multilayer barrier film while Figure 1B enlarges a specific section of the multilayer barrier film in which the defects which occur in a barrier layer are shown. Those, cracks, pinholes or gaps at grain boundaries are generated during the manufacturing process of such layers, such as sputtering processes, and cannot be avoided. As described herein the inventors found a method of closing those defects by depositing in a two step method (depositing seed layer and growing them in a thermal solvent method) a nanostructured metal compound layer 51, wherein the nanostructured material of the nanostructured metal compound layer plugs the defects (gray filled part in the defects shown in the barrier layer 51) in the barrier layer rather than only covering them up. In Figure 1A it is shown that the substrate layer 50 is followed by a barrier layer 51 which is in direct connection with a nanostructured metal compound layer 60 which plugs the defects. The nanostructured metal compound layer 60 is followed by a planarising layer 70.
**Figure 2** shows a further embodiment, in which the basic structure referred to in Figure 1 is shown. In addition, Figure 2 shows a further layer 80 which is deposited on the planarising layer 70. The layer 80 can be any kind of further barrier layer as outlined in the specification. Layer 80 can be for example another barrier layer which is made of the same or a different material than the barrier layer 51. Layer 80 can also be another succession of barrier layer, nanostructured metal compound layer and optionally a planarising layer, i.e. a further multilayer structure or layer 80 can be any kind of barrier layer known in the art.

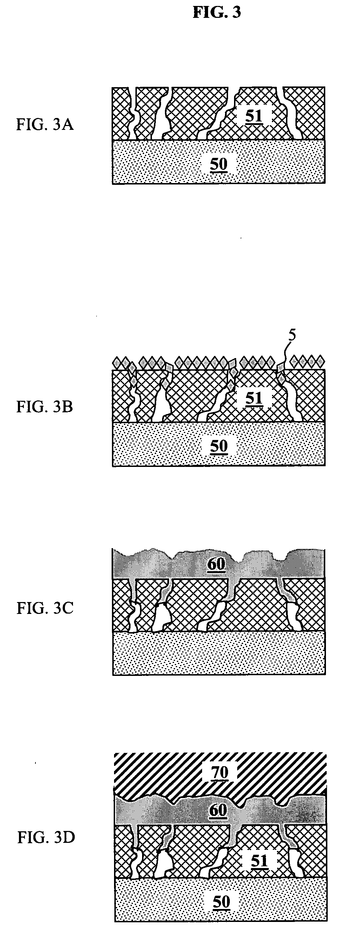

**Figure 3** illustrates the manufacturing process of the multilayer barrier film described herein.

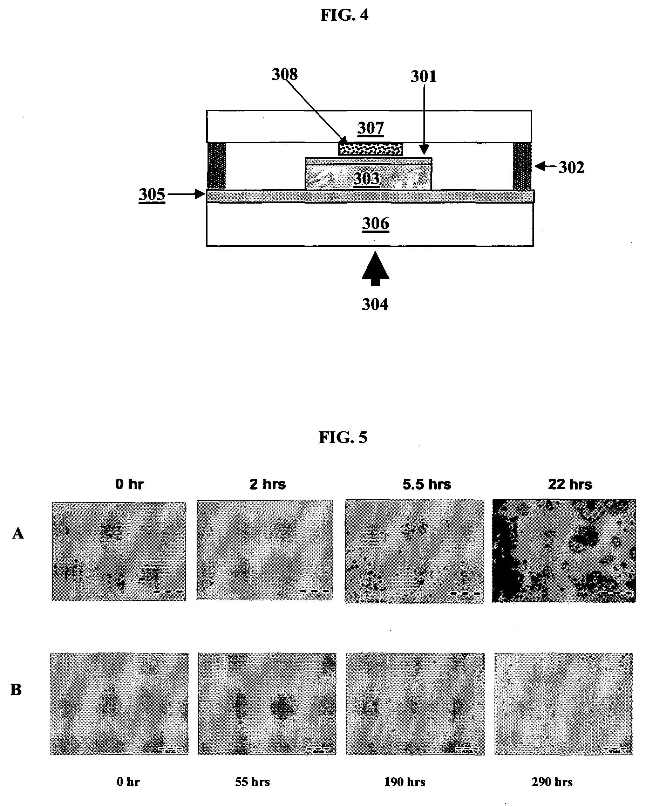

**Figures 4** shows a setup for carrying out an investigation of the barrier film properties of fabricated barrier films using a calcium sensor 304.
**Figure 5** shows the results of a calcium degradation test of a conventional barrier stack compared to a multilayer barrier film described herein.
**Figure 6** illustrates the operation method of a barrier film known in the art and the limitations of such barrier films. This barrier film includes three different layers. Two metal oxide layers 106 which are interposed by a polymer layer 110. The metal oxide layers are applied on the top and bottom of the polymer layer to improve the barrier properties. Compared to polymers, metal oxides are known to adsorb water vapour (adsorption indicated by arrow 107) much better than polymer films. However, as already explained in the introductory part, the metal oxide layers comprise inherent structural defects, such as defects which occur at the boundaries of metal grains 101 which form the metal oxide layer; cracks 102, which can form upon bending of the flexible barrier film; and pinholes 103. The water molecules 108 and oxygen molecules (not shown in Figure 6) can pass the metal oxide layer through these defects, diffuse through the polymer layer 110 (diffusion indicated by diagonal arrow 104) and are released from or through the surface (desorption) of the metal oxide layer 106 into the area in which the moisture sensitive device to be protected is positioned.
Figure 7 shows SEM pictures indicating the surface topography properties of the barrier layer (A), a seed layer (B), the nanostructured metal compound layer during (C) and after (D) growth of the seeds (C & D) and the planarising layer (E).

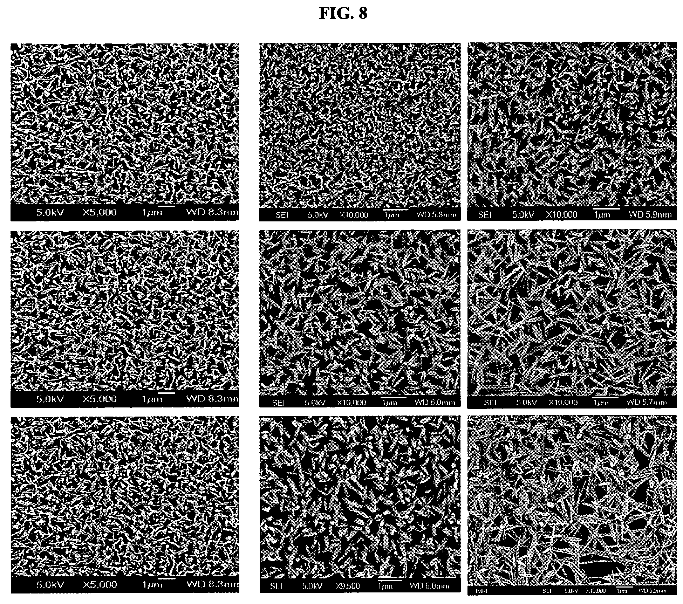

**Figure 8** illustrates the influence of different concentrations of zinc oxide and different spin speeds in the manufacture of a nanostructured metal compound layer. The first row of images shows the nanostructured metal compound layer, which is made of ZnO nanorods which have been obtained via electrospinning at a spin speed of 3000 rpm In the second row the spin speed was 4000 rpm and in the third row the spin speed was 5000 rpm In the first column the concentration of ZnO nanoparticles used in the solution for spin coating was 0.075 M, in the second column the concentration was 0.0093 M and in the third column the concentration was 0.0068 M.

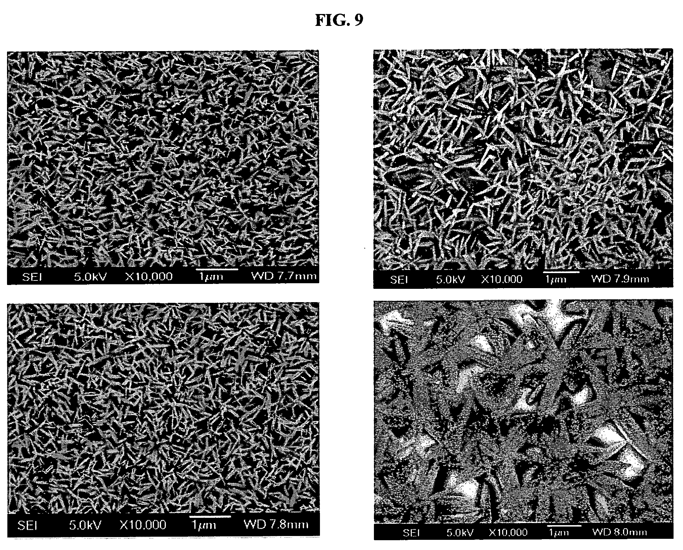

**Figure 9** illustrates the influence of different concentrations of zinc oxide and spin speeds in the manufacture of a nanostructured metal compound layer. The first row of images shows the nanostructured metal compound layer, which is made of ZnO nanorods which have been obtained via electrospinning at a spin speed of 3000 rpm. In the second row the spin speed was 4000 rpm. In the first column the concentration of ZnO nanoparticles used in the solution for spin coating was 0.075 M, in the second column the concentration was 0.0057 M.

### DETAILED DESCRIPTION OF THE INVENTION

In a first aspect, the present invention is directed to a multilayer barrier film. The multilayer barrier film comprises:
▪ a substrate layer coated on one side with a barrier layer, wherein the barrier layer is made of a material selected from the group consisting of a metal oxide, a metal carbide, a metal nitride and a metal oxinitride;
▪ a nanostructured metal compound layer arranged on the barrier layer; and
▪ a planarising layer arranged on the nanostructured layer, wherein the planarising layer comprises a nanostructured material which is distributed in a polymeric binder, wherein the nanostructured material is made of a carbon, a metal or a metal oxide or a mixture of the aforementioned substances.

In this barrier film configuration any defects present in the barrier layer coated onto the substrate are sealed by depositing a nanostructured metal compound layer. Figure 1 illustrates an example of such a configuration. The substrate 50 is coated with a barrier layer 51 comprising defects as illustrated in more detail in the inset to Figure 1. The nanostructured metal compound layer 60 following the barrier layer propagates into the defects of the barrier layer and does not simply create another layer which only covers the defects of the barrier layer. Thus, an efficient barrier effect against moisture and oxygen can be obtained as illustrated in the experimental section. Application of a planarising layer further allows to smoothen the surface in case further barrier layers are intended to be deposited on the barrier film to further decrease the oxygen transmission rate (OTR) below 10⁻⁵ cc/m²/day and water vapor transmission rate (WVTR)to below 10⁻⁶g/m²/day.

In addition, the nanostructured layer can diffuse incoming light by light scattering. This light scattering can be useful in applications in which this barrier film is used to protect solar cells & organic/inorganic emissive devices against moisture and/or oxygen.

The substrate or flexible substrate used in the barrier film can be made of a polymer, such as an organic polymer or an inorganic polymer. Examples of organic polymers include, but are not limited to polyacetate, polypropylene, cellophane, poly(1-trimethylsilyl-1-propyne, poly(ethylene-2,6-naphthalene dicarboxylate) (PEN), poly(ethylene terephthalate) (PET), poly(4-methyl-2-pentyne), polyimide, polycarbonate (PC), polyethylene, polyethersulfone (PES), epoxy resins, polyethylene terephthalate, polystyrene, polyurethane, polyacrylate, polyacrylamide, polydimethylphenylene oxide, styrene-divinylbenzene copolymers, polyolefin, polyvinylidene fluoride (PVDF), nylon, nitrocellulose, cellulose or acetate. In one embodiment, the substrate does not comprise any metallic materials. Examples for such metallic materials can include but are not limited to metal particle or metal oxide particle.

Polycarbonate is a useful substrate because it is compatible with plastic electronics fabrication processes. Polycarbonate is also transparent and can be cut into any desired dimension. Pneumatically operated hollow die punch-cutting equipment or any other conventional slitting machine can be used to slit samples into desired dimensions.

The substrate may be arranged to face the external environment and or it may face the environment encapsulated be the graded barrier film. In food packaging, the substrate may face the internal surface that is in contact with food while the graded barrier film forms the external surface in contact with atmospheric conditions.

Examples of inorganic substrates include, but are not limited to silica (glass), nano-clays, silicones, polydimethylsiloxanes, biscyclopentadienyl iron, indium tin oxide, polyphosphazenes and derivatives thereof In another embodiment, the substrate used can be transparent or semi-transparent or opaque. The substrate layer can have a thickness of between about 1 µm to about 3 µm or about 1 µm, or about 1.5 µm, or about 2 µm, or about 2.5 µm, or about 3 µm.

The barrier layer coated onto the substrate layer can be made of known barrier materials. Materials for barrier layers are known and in general those materials are chosen which are capable of interacting with moisture and/or oxygen thus achieving low gas permeability. A barrier layer can be made of a material such as a metal oxide, a metal carbide, a metal nitride or a metal oxynitride. The barrier layer can have a thickness of between about 5nm to about 500 nm or from about 5 nm to about 250 nm or from about 5 nm to about 100 nm, or from about 5nm to about 50 nm, or from about 20 nm to about 100 nm, or from about 50 nm to about 500 nm or at least 5 nm or at least 10 nm, or at least 50 nm.

The metal used as basis for the metal carbide, metal sulfite, metal phosphate, metal, metal nitride, metal oxynitride can comprise a metal from periodic groups 2 to 14 (IUPAC; according to IUPAC recommendations until 2006; periodic system published by Wiley-VCH Verlag GmbH & Co. KGaA, Weinheim, 4th edition, 2007). Examples for such metals include, but are not limited to aluminium, gallium, indium, indium-doped tin, thallium, titanium, zirconium, hafnium, molybdenum, chromium, tungsten, zinc, silicon, germanium, tin, barium, strontium, calcium, magnesium, manganese, tantalum, yttrium and vanadium and alloys thereof Some preferred metals include those from Groups 2, 4, 10, 12, 13 and 14 (IUPAC). For example, these metals may be selected from Al, Mg, Ba and Ca. Reactive transition metals may also be used, including Ti, Zn, Sn, Ni, and Fe for instance.

Examples for metal oxides which can for example be used for the barrier layer, the nanostructured metal compound layer as well as in the planarising layer, include, but are not limited to TiO₂, Al₂O₃, ZrO₂, ZnO, BaO, SrO, CaO and MgO, VO₂, CrO₂, MoO₂, and LiMn₂O₄. In some embodiments, the metal oxide may comprise a transparent conductive metal oxide which can include, but is not limited to cadmium stannate (Cd₂SnO₄), cadmium indate (CdIn₂O₄), zinc stannate (Zn₂SnO₄ and ZnSnO₃), and zinc indium oxide (Zn₂In₂O₅).

Exampels of metal nitrides that can be used include, but are not limited to TiN, AlN, ZrN, Zn₃N₂, Ba₃N₂, Sr₃N₂, Ca₃N₂ and Mg₃N₂, VN, CrN or MoN. Exampels of metal oxynitrides that can be used include, but are not limited to TiOₓN_{y} such as TiON, AlON, ZrON, Zn₃(N₁₋ₓOₓ)_{2-y}, SrON, VON, CrON, MoON and stoichiometric equivalents thereof Examples of metal carbides include, but are not limited to hafnium carbide, tantalum carbide or silicon carbide.

The barrier layer coated onto the substrate layer comprises inevitable some defects, such as pinholes, cracks and gaps occurring at grain boundaries of the metallic barrier layer material used (see also Figure 6). The nanostructured metal compound layer deposited onto the barrier layer is manufactured in a way that the defects in the underlying barrier layer are not only masked or covered but are filled up either completely or partially with the nanostructured metal compound used for the nanostructured metal compound layer. Thus, water and oxygen are not only effectively blocked by the material of the nanostructured metal compound layer once the water and oxygen molecules passes through the defects of the metal oxide layer but the water and oxygen molecules are already stopped from getting into the bulk of the nanostructured metal compound layer deposited on the barrier layer.

The nanostructured metal compound layer can be made of a metal sulfite, a metal phosphate, a metal, a metal nitride, a metal oxynitride or a metal oxide.

Examples for useful metals, metal nitrides, metal oxynitrides or metal oxides have already been disclosed above. Examples of metal sufides include, but are not limited to CdS, ZnS or PbS. Examples of metal phosphates include, but are not limited to InP and GaP. In one embodiment, the nanostructured metal compound layer is made of a metal oxide, such as ZnO₂.

The nanostructure of the metal compound used in the nanostructured metal compound layer is obtained using a combination of conventional coating methods for the deposition of a seed layer of a metal compound and a solvent thermal method for growing the nanostructures based on the metal compound seeds. The nanostructures obtained by using those methods can be a nanowire, a single-crystal nanostructure, a double-crystal nanostructure, a polycrystalline nanostructure and an amorphous nanostructure.

The nanostructures, such as a nanowire, of the metal compound in the nanostructured metal compound layer may comprise at least one dimension in the range of between about 200 nm and 1 µm while another dimension may be in the range of between about 200 mm to about 1 µm.

The nanostructured metal compound layer can have a thickness of between about 200 nm to about 10 µm. In another embodiment, the thickness may be between about 200 nm to about 5 µm, or between about 200 nm to about 2 µm or between about 200 nm to about 1 µm, or at least 200 nm. The thickness of the nanostructured metal compound layer is not uniform which is partly due to the fact that the growth of the nanostructures in the nanostructured metal compound layer is not regular.

Thus, the barrier film can further include a planarising layer which is deposited on the surface of the nanostructured metal compound layer. The planarising layer can comprise a nanostructured material which is made of carbon, or a metal, or a metal oxide or a mixture of the aforementioned substances. The metal or metal oxide can include any of the metals or metal oxides referred to above.

The planarising layer refers generally to a layer in which nanostructured particles are distributed. The layer may comprise any suitable sort of binder for holding the nanostructured particles, such as pure polymers, polymer solutions and polymer composites. The nanostructured material is capable of interacting with moisture and/or oxygen, either by way of chemical reaction (e.g. hydrolysis or oxidation), or through physical or physicochemical interaction (e.g. capillary action, adsorption, hydrophilic attraction, or any other non-covalent interaction between the nanoparticles and water/oxygen) to bring about the removal of moisture and oxygen from the gas permeating the previous layers.

In one embodiment, the nanostructured material of the planarising layer comprises or consists of nanostructured carbon material, such as carbon nanotubes, nanoribbons, nanofibres and any regular or irregular shaped carbon particle with nanoscale dimensions. For carbon nanotubes, single-walled or multi-walled carbon nanotubes may be used. In a study carried out by the present inventors, it was found that carbon nanotubes (CNTs) can serve as a desiccant. Carbon nanotubes can be wetted by low surface tension liquids via capillary action, particularly liquids whose surface tension does not exceed about 200 Nm⁻¹ (Nature, page 801, vol. 412, 2001). In principle, this would mean that water molecules can be drawn into open-ended carbon nanotubes by capillary suction. It is suggested that water molecules may form quasi-one-dimensional structures within carbon nanotubes, thereby helping to absorb and retain a small volume of oxygen and water molecules.

Inert nanoparticles may be included in the planarising layer, present in conjunction with nanostructured material. As used herein, "inert nanoparticles" refer to nanoparticles which do not interact at all with moisture and/or oxygen, or which react to a small extent as compared to nanostructured material. Such inert nanoparticles may be included into the planarising layer to obstruct the permeation of oxygen and/or moisture. Examples of inert particles include nanoclays as described in US Patent No. 5,916,685.

Other suitable materials for inert nanoparticles may also include metals such as copper, platinum, gold and silver; minerals or clays such as silica, wollastonite, mullite, monmorillonite; rare earth elements, silicate glass, fluorosilicate glass, fluoroborosilicate glass, aluminosilicate glass, calcium silicate glass, calcium aluminium silicate glass, calcium aluminium fluorosilicate glass, titanium carbide, zirconium carbide, zirconium nitride, silicon carbide, or silicon nitride, metal sulfides, and a mixture or a combination thereof.

It is also possible to use a combination of different types of nanostructured materials in the planarising layer. Thus, the planarising layer can comprise at least two types of nanostructured materials. By studying the absorption/reaction characteristics of different types of nanostructured materials, it is possible to select a combination of nanostructured materials which compliment each other to achieve barrier effects that are stronger than that which is possible with a single type of material.

Therefore, the planarising layer may comprise a combination of carbon nanotubes and nanostructured metal and/or metal oxide. One exemplary embodiment is directed to the inclusion of both a nanostructured metal oxide, such as TiO₂/Al₂O₃ as well as carbon nanotubes. In an exemplary embodiment, the quantity of nanostructured metal oxide present is between 500 to 15000 times (by weight) the quantity of carbon nanotubes. For oxides of metals having low atomic weight, lower ratios can be used. For example, nanostructured TiO₂ can be used in combination with carbon nanotubes, with the weight ratio of carbon nanotubes to TiO₂ being between about 1:10 to about 1:5, but not limited thereto.

The concentration of nanostructured material in the planarising layer can be varied. In one embodiment, the amount of nanostructured material added to a monomer solution for forming the planarising layer is in the range of about 0.0000001%, about 0.0001%, about 0,001%, about 0.01%, about 0.1%, or about 1.0% to about 10, 20, 30, 40 or 50 % by volume of the by weight of the monomer present in the polymeric binder of the planarising layer. In other embodiments the amount of nanoparticles added to a monomer solution for forming the planarising layer is to about 10%, about 20%, about 30 % or about 40 % by volume to the weight of the monomer present in the polymeric binder. In the case of carbon nanotubes, they may be also used in quantities from about 0.01 % to about 10 %, about 20%, about 30 %, about 40% or about 50 % by weight of the monomer present. In one illustrative embodiment carbon nanotubes are added in quantities of about 0.01% to about 10% by volume to the weight of the monomer present.

The nanostructured material in the planarising layer may have shapes that allow maximising the surface area that can come into contact with the water vapour and oxygen in the planarising layer. This means that the nanoparticles may be designed to have a large surface area to volume ratio, or surface area to weight ratio. In one example, the nanoparticles have a surface area to weight ratio of between about 1 m²/g to about 50 or 100 or 200 m²/g. This requirement can be achieved by using nanoparticles with different shapes, such as 2, 3 or more different shapes. At least one dimension of the nanoparticles in the planarising layer is between about 20 nm to about 60 nm. Possible shapes that the nanoparticles can assume include spherical shapes, rod shapes, elliptical shapes or any irregular shapes. In the case of rod shaped nanostructured materials in the planarising layer, they may have a diameter of between about 20 nm to 50 nm, a length of 50 to 200 nm, and an aspect ratio of more than 5, but not limited thereto.

The nanostructured material of the planarising layer is dispersed in a polymeric binder. The polymeric binder may be obtained from any suitable polymerisable compounds (precursor) having at least one polymerisable group. Examples of polymerisable compounds suitable for this purpose include, but are not limited to, polyacrylate, polymethacrylate, polyacrylamide, polyepoxide, parylene, polysiloxanes or polyurethane, or any other polymer, and may be derived from their corresponding monomer compounds.

The thickness of the planarising layer depends on the height of the nanostructures in the nanostructured metal compound layer and the thickness should be sufficient to cover the nanostructures forming the nanostructured metal compound layer. Therefore, in one embodiment the planarising layer has a thickness between about 200 nm and 1 µm.

In one embodiment, the polymeric binder in the planarising layer is derived from ultra-violet (UV) light curable monomers. The advantage of using UV curable monomers is that curing time is almost instantaneous and planarising layers obtained thereof have excellent chemical resistance. Examples of UV light curable monomers include polyfunctional monomers, such as di- or tri- functional monomers. Suitable examples of such polyfunctional monomers include, without limitation, alkylenediol di(meth)acrylates such as 1,6-hexanediol diacrylate and neopentyl glycol diacrylate, cyclohexanedimethylol diacrylate, polyalkylene glycol di(meth)acrylates such as triethylene glycol diacrylate, ether modified monomers such as propoxylated neopentyl glycol diacrylate, and higher functionality monomers such as trimethylolpropane triacrylate, trimethylolethane triacrylate, and pentaerythritol tetracrylate, and so on, as well as combinations of such polyfunctional monomers. Apart from UV-curable monomers, other types of monomers that can be polymerised through exposure to standard halogen light curing units may be used as well. For example, polymers that can be cured through exposure to light from blue superbright light emitting diodes at a wavelength of 400 nm and above may also be used.

For UV curable monomers, in order to accelerate the curing of the nanostructured layer, a photo-initiator may be included into the precursor mixture containing the monomers. Examples of suitable photo-initiators include, without limitation, benzoin ethers such as benzoin methyl ether, benzoin ethyl ether, benzoin phenyl ether, and so on; alkylbenzoins such as methylbenzoin, ethylbenzoin, and so on; benzyl derivatives including benzyldimethylketal; 2,4,5-triarylimidazole dimers including 2-(o-chlorophenyl)-4,5-diphenylimidazole dimer, 2-(o-chlorophenyl)-4,5-di(m-methoxyphenyl)imidazole dimer, 2-(o-fluorophenyl)-4,5-phenylimidazole dimer, 2-(o-methoxyphenyl)-4,5-diphenylimidazole dimer, 2-(p-methoxyphenyl)-4,5-diphenylimidazole dimer, 2,4-di(p-methoxyphenyl)-5-phenylimidazole dimer, 2-(2,4-dimethoxyphenyl)-4,5-diphenylimidazole dimer, and so on; acridine derivatives such as 9-phenylacridine and 1,7-bis(9,9'-acridinyl)heptane; N-phenylglycine; aromatic ketones such as trimethylbenzophenone, isopropylthioxanthone, benzophenone, 2-chloro and 2-ethyl-thioxanthone, 2,2-dimethoxy-2-phenylacetophenone, 2,2-diethoxyacetophenone, 2-hydroxy-2-methyl-1-phenyl-propanone, oligo-[2-hydroxy-2-methyl-1-[4-(1-methylvinyl)phenyl]propanone, 1-hydroxycyclohexyl-acetophenone, and 2-ethyl-hydroquinone; phosphine oxides, such as 2,4,6-trimethylbenzoyldiphenylphosphine oxide, and combinations thereof.

In one embodiment, the planarising layer can further include an UV absorbing organic compound. Such a compound can include, but is not limited to 4-methylbenzylidene camphor, isoamyl p-methoxycinnamate, 2-hydroxyphenyl benzotriazole, 2-hydroxy-benzophenone, 2-hydroxy-phenyltriazine or oxalanilide.

In one embodiment, the substrate is coated on both sides with (in this order) the barrier layer, the nanostructured metal compound layer and the planarising layer.

In another embodiment, it is possible that a further barrier layer is arranged on the planarising layer, i.e. the planarising layer is coated with a barrier layer. The composition of the barrier layer can be the same or different from the barrier layer coated onto the substrate. An exemplary embodiment is illustrated in Figure 2. Figure 2 shows a substrate 50 coated with a first barrier layer 51. The nanostructured metal compound layer 60 is arranged on the first barrier layer. The planarising layer 70 is arranged on the nanostructured metal compound layer 60. The planarising layer 70 is followed by a second barrier layer. Instead of a second barrier layer it is also possible to coat any other known layered arrangement with barrier properties as the one described above (against water and oxygen) onto the planarising layer.

In a further embodiment, the planarising layer 70 or the second barrier layer 80 is coated with a terminal layer which protects the multilayer barrier film described herein from mechanical damage. Thus, the multilayer barrier film may be capped or overlaid with a terminal protective layer. The terminal layer may comprise any material having good mechanical strength and is scratch resistant. In one embodiment, the terminal layer comprises an acrylic film having distributed therein LiF and/or MgF₂ particles.

In still another embodiment, the configuration of layers as illustrated in Figure 2 is provided. It is now also possible to coat the second barrier layer with a second nanostructured metal compound layer followed by a second planarising layer. Thus, the process of deposition a nanostructured metal compound layer to close the defects in the underlying barrier layer is repeated. However, in that case the application of a further planarising layer is optional and depends on the question whether further layers shall follow which would then be coated onto the planarising layer.

In another aspect, the present invention is directed to a method of manufacturing a multilayer barrier film as described herein. Such a method can comprise
▪ providing a barrier layer coated substrate;
▪ applying a solution of a metal particle precursor dissolved in an organic solvent on the barrier layer to obtain a seed layer;
▪ growing metal nanocrystals via a solvent thermal method to obtain a nanostructured metal compound layer;
▪ depositing a planarising layer on the nanostructured metal compound layer.

The method of manufacturing a substrate coated with a barrier film is known in the art. In general, the surface of the substrate is cleaned to remove macro scale adsorbed particles from the surface of the substrate. Such a process can be carried out by rinsing the substrate with an alcohol, such as isopropyl alcohol (IPA) and subsequently blow drying the surface with an inert gas, such as nitrogene. After blow-drying the surface the substrate can be placed in a vacuum chamber to remove any absorbed moisture or oxygen from the substrate. The vacuum treatment can be followed by a plasma treatment to remove surface contaminants.

The barrier layer can be coated onto the substrate layer using sputtering techniques known in the art.

Sputtering is a physical process of depositing thin films by controllably transferring atoms from a source to a substrate which is known in the art. The substrate is placed in a vacuum chamber (reaction chamber) with the source material, named a target, and an inert working gas (such as argon) is introduced at low pressure. A gas plasma is struck in radio frequency (RF) or direct current (DC) glow (ejection of secondary electrons) discharged in the inter gas, which causes the gas to become ionized. The ions formed during this process are accelerated towards the surface of the target, causing atoms of the source material to break off from the target in vapor form and condense on the substrate.

Besides RF and DC sputtering, magnetron sputtering is known as third sputtering technique. For magnetron sputtering, DC, pulsed DC, AC and RF power supplies can be used, depending upon target material, if reactive sputtering is desired and other factors. Plasma confinement on the target surface is achieved by locating a permanent magnet structure behind the target surface. The resulting magnetic field forms a closed-loop annular path acting as an electron trap that reshapes the trajectories of the secondary electrons ejected from target into a cycloidal path, greatly increasing the probability of ionization of the sputtering gas within the confinement zone. Positively charged argon ions from this plasma are accelerated toward the negatively biased target (cathode), resulting in material being sputtered from the target surface.

Magnetron sputtering differentiates between balanced and unbalanced magnetron sputtering. An "unbalanced" magnetron is simply a design where the magnetic flux from one pole of the magnets located behind the target is greatly unequal to the other while in a "balanced" magnetron the magnetic flux between the poles of the magnet are equal. Compared to balanced magnetron sputtering, unbalanced magnetron sputtering increases the substrate ion current and thus the density of the substrate coating.

Therefore, in one embodiment a sputtering technique such as RF sputtering, DC sputtering or magnetron sputtering is used to deposit the barrier layer onto the substrate layer. The magnetron sputtering can include balanced or unbalanced magnetron sputtering. In one embodiment, the barrier layer is a sputtered barrier layer.

To obtain barrier layers other than pure metal layers, such as mixtures of different metals or metal oxide layers, or metal nitride layers or metal oxynitride layers, the inert reaction gas, such as argon, is mixed with oxygen (for metal oxides), or nitrogen (for metal nitride), or oxygen and nitrogen (for metal oxynitride) in the reaction chamber of the sputtering device. Barrier layers of metal carbides can be obtained by using a target made of metal carbide (e.g. hafnium carbide or tantalum carbide or silicon carbide).

After depositing the barrier layer onto the substrate layer, the nanostructured metal compound layer is formed. Different methods which can be used to manufacture such a nanostructured metal compound layer are known in the art and are described for example by Yiamsawas, D., Boonpavanitchakul, K, et al. (2009, Journal of Microscopy Society of Thailand, vol.23, no.1, pp.75), Shah, M.A. (2008, African Physics Review, vol.2:0011, pp.106) or Hossain, M.K, Ghosh, S.C., et al. (2005, J. of Metastable and Nanocrystalline Materials, vol.23, pp.27).

Formation of the nanostructured metal compound layer may comprise two different process steps. In a first step a seed layer of a metal compound is deposited onto the barrier layer. The metal compound seeds in this initial layer have a size of between about 5 nm to 200 nm. The thickness of the seed layer is in general between about 2 to 50 nm. Depositing the initial seed layer is carried out using conventional coating methods, such as spin coating, slot die coating, screen printing, ink jet printing or any other imprinting methods. Roll-to-roll methods such as tip coating can also be used.

For example, in electrospinning, a solid fiber is generated as the electrified jet (composed of a highly viscous polymer solution) which is continuously stretched due to the electrostatic repulsions between the surface charges and the evaporation of solvent. As the fiber travels toward the surface of the collector, evaporation of the solvent in which the polymer is dissolved occurs and the fiber is typically dry when arriving at the surface of the collector. In the present case the collector would be the barrier layer.

In one embodiment for the manufacture of the seed layer, a suspension of metal compound nanoparticles was prepared by stirring a solution containing a base, such as KOH, and a metal precursor, such as ZnO-acetate in methanol or ethanol at an elevated temperature, such as 60°C for a sufficient time, such as for 2 hours. The size of these nanoparticle seeds is typically 10 to 20 nm in diameter. Then, the barrier layer coated substrate is spin-coated a few times at 2000 to about 5000 rpm for a few seconds, such as 30 s, with these metal compound nanoparticle seeds. This is followed by a thermal anneal at elevated temperature, such as 150 °C for a few minutes or nitrogen ambient to form a metal compound seed layer.

After depositing a seed layer of a metal compound onto the barrier layer, the seed growth and thus the growth of the nanostructured layer is initiated by a solvent thermal route.

After providing a seed layer of a metal compound on the surface of the barrier layer (pre-prepared structure), such as by electrospinning, the growth of the metal compound seeds can be initiated using different methods. In one method, a metal compound precursor, such as zinc acetate, is dissolved in water at about room temperature. Afterwards, the solution is basified, for example by addition of ammonium hydroxide. The resulting suspension is transferred into an autoclave. The pre-prepared structure is immersed in the solution placed in the autoclave and subjected to a hydrothermal treatment. The temperature can be chosen to be in the range of between about 70 to 150°C or about 80 to 90°C. The hydrothermal treatment in the autoclave is carried out for a time which allows growth of the nanostructures forming the nanostructured metal compound layer. The time for the hydrothermal treatment can be between about 5 min to about 2 hours or about 5 min to about 60 minutes, or about 60 min. Afterwards, the autoclave is left to cool down to room temperature.

In another method, the barrier coated substrate comprising the seed layer deposited onto the barrier layer (pre-prepared structure) is subjected to a solution of a metal precursor and a base in deionized water. To do so the pre-prepared structure is fixed to a holder so that the substrate of the pre-prepared structure is facing away from the solution comprising the metal precursor and the base. Afterwards the solution is subjected to a temperature between about 60°C to about 85°C for a time of between about 30 min to 3 h depending on the length of the nanostructured which are to be obtained.

Another hydrothermal method that can be used for the growth of metal compound particles does not use water and is carried out according to the method described by Yiamsawas, D., Boonpavanitchakul, K., et al. (2009, *supra*). In this article the synthesis of ZnO was carried out by a solvo thermal process at 80°C. Poly(vinyl pyrrolidone) PVP 30K was dissolved in absolute ethanol under stirring at room temperature, then zinc acetate dihydrate was slowly added to the solution. Consequently, the solid NaOH was put into the reaction mixture. The resulting solution was stirred for several minutes. The solution was then transferred to polypropylene vessel, then sealed and heated in temperature-controlled autoclave at 80°C for 24 h. After cooling to room temperature, the white powder was precipitated and then washed with absolute ethanol several times to dissolve other impurities. Finally, the powder was dried under vacuum at 60°C overnight and determined in terms of their structural, morphology and optical properties. The mixed solvent of ethylene glycol and absolute ethanol without polymer template was also investigated.

The planarising layer may be formed by conventional polymer coating techniques. Methods that can be used include, for example spin coating, as described above, CVD or plasma polymerization methods or web flight coating.

By "consisting of" is meant including, and limited to, whatever follows the phrase "consisting of". Thus, the phrase "consisting of' indicates that the listed elements are required or mandatory, and that no other elements may be present.

By "comprising" it is meant including, but not limited to, whatever follows the word "comprising". Thus, use of the term "comprising" indicates that the listed elements are required or mandatory, but that other elements are optional and may or may not be present.

The inventions illustratively described herein may suitably be practiced in the absence of any element or elements, limitation or limitations, not specifically disclosed herein. Thus, for example, the terms "comprising", "including", "containing", etc. shall be read expansively and without limitation. Additionally, the terms and expressions employed herein have been used as terms of description and not of limitation, and there is no intention in the use of such terms and expressions of excluding any equivalents of the features shown and described or portions thereof, but it is recognized that various modifications are possible within the scope of the invention claimed. Thus, it should be understood that although the present invention has been specifically disclosed by preferred embodiments and optional features, modification and variation of the inventions embodied therein herein disclosed may be resorted to by those skilled in the art, and that such modifications and variations are considered to be within the scope of this invention.

The invention has been described broadly and generically herein. Each of the narrower species and subgeneric groupings falling within the generic disclosure also form part of the invention. This includes the generic description of the invention with a proviso or negative limitation removing any subject matter from the genus, regardless of whether or not the excised material is specifically recited herein.

Other embodiments are within the following claims and non-limiting examples. In addition, where features or aspects of the invention are described in terms of Markush groups, those skilled in the art will recognize that the invention is also thereby described in terms of any individual member or subgroup of members of the Markush group.

### Experiments

### Surface Preparation of substrate

Substrates that are used as support structure for the graded barrier film are rinsed with isopropyl alcohol (IPA) and blown dry with nitrogen. These processes help to remove macro scale adsorbed particles on the substrate surface. Acetone and methanol cleaning or rinsing can be carried out but is not recommended.

Subsequently, substrates are placed in a vacuum oven at a pressure of 10⁻¹ mbar for degassing absorbed moisture or oxygen. The vacuum oven is equipped with fore line traps to prevent back migration of hydrocarbon oil from vacuum pump to the vacuum oven.

Immediately after degassing, substrates are transferred to the plasma treatment chamber (e.g. ULVAC SOLCIET, Cluster Tool). Radio Frequency (RF) argon plasma is used to bombard surface of the barrier film with low energy ions to remove surface contaminants. Base pressure in the chamber was maintained below 4 x 10⁻⁶ mbar. Argon flow rate is 70 sccm (116.2*10⁻³ Pa*m³/s). RF power is set at 200 W, and an optimal treatment time, depending on the surface condition, of usually 5 to 8 eight minutes was used.

### Coating substrate with barrier layer

Sputtering technique was used to deposit the metal oxide barrier layer. An unbalanced magnetron sputter system is used to develop high density oxide barrier films. In this sputtering technique, a metal layer of typically a few mono-layers is deposited from an unbalanced magnetron. Subsequently, oxygen is introduced to the system to create oxygen plasma which is directed towards the substrate to provide argon and oxygen ion bombardment to achieve a high packing-density oxide film. This plasma also increases reactivity of oxygen directed onto the growing film surface, and provides for more desirable structures. In order to deposit dense films without introducing excessive intrinsic stresses, a high flux (greater than 2 mA/cm²) of low energy (∼25 eV) oxygen and argon ions are used to bombard the growing barrier oxide films.

A continuous feedback control unit is used to control the reactive sputtering processes. The light emitted by the sputtering metal in the intense plasma of the magnetron racetrack is one indicator of the metal sputtering rate and the oxygen partial pressure. This indication can be used to control the process and hence achieve an accurate oxide film stoichiometry. By using a continuous feedback control unit from a plasma emission monitor, reproducible films and desirable barrier properties are obtained.

Various barrier layers including silicon nitride (SiN), aluminium oxide (Al₂O₃), and indium tin oxide (ITO) were prepared by conventional and unbalanced magnetron sputtering techniques.

### Seed layer deposition for formation of nanostructured metal compound layer

Commercially available nanoparticle dispersions of zinc oxide or titanium oxide dispersed in hexane diol diacrylate or isobornyl acrylate or tripropylene glycol diacrylate can be used to deposit ZnO₂ or TiO₂ nanodots (20 to 50 nm) onto the barrier layer using spin coating. Commercially available nanoparticle dispersions of zinc oxide or titanium oxide dispersed in hexane diol diacrylate or isobornyl acrylate or tripropylene glycol diacrylate was used to deposit ZnO₂ or TiO₂ nanodots (20 to 50 nm) onto the barrier layer using spin coating. The nanoparticle dispersion comprised nanoparticles in a concentration of about 35 % by weight of the total dispersion.

After the deposition, the residual solvent can be removed at thermal annealing at 80°C for few minutes can take place. The influence of different spin speeds has been assessed by using spin speeds of 3000, 4000 and 5000 rpm. As can be seen from Figure 8, the different spin speeds do not influence the structure of the resulting ZnO crystals.

In an alternative method (method 2) of applying the seed layer, a suspension of ZnO nanoparticles was prepared by stirring a solution containing potassium hydroxide and zinc acetate (5 to 10 mg) in methanol (10 ml to 20 ml), or ethanol, at 60 °C for 2 h. The size of these nanoparticles is typically 10 to 20 nm in diameter. Then, the substrate is spin-coated 3-5 times at 2000-5000 rpm for 30 s with these ZnO nanoparticles. This is followed by a thermal anneal at 150°C for few minutes or nitrogen ambient to form a ZnO seed layer.

### Growth of metal compound seeds to form nanostructured metal compound layer

A solvent thermal route is used to grow zinc oxide nanodots by exposing the seed layer comprising the zinc nanodots to a solution comprising zinc acetate and ammonium hydroxide. Zinc acetate was dissolved in deionized water at room temperature. Afterwards ammonium hydroxide was added to obtain a pH of about 10. The resulting suspension was transferred into Teflon-lined stainless steel autoclave. Next, the pre-prepared structure described above under "Seed layer deposition for formation of nanostructured metal compound layer" was immersed in the suspension in the autoclave and subjected to a hydrothermal treatment. The hydrothermal treatment was carried out at a temperature of about 80 to 90°C for about 60 minutes. Afterwards the autoclave was left to cool down to room temperature. During the hydrothermal treatment, zinc oxide nanodots will ripen to nanorod morphologies at temperatures of 60°C to 120 °C within a time of 5 min to 60 min. In another embodiment, a temperature of 60°C has been used and the incubation time for the seed layer with the solution of zinc acetate and ammonium hydroxide is five minutes. Use of nanodots as nuclei is one of the approaches that will allow for controlled growth of higher aspect ratio nanorods. Several solvent thermal routes and hydrolysis processes exist that can be employed to grow the zinc nanorods on to the barrier layer. The atomic force microscope (AFM) photographs of nanodots (seed layer) and nanostructures (after growth) are shown in Figure 7B and Figure 7C respectively.

In case the seed layer is deposited following method 2 as described above, the growth of the seeds is carried out as follows:

Growth of ZnO nanorods is carried out in a solution consisting of zinc acetate dihydrate (0.27 M to 0.0079 M) and ammonium hydroxide (0.00069 M) in deionized water, prepared at room temperature. The substrate is suspended using a sample holder in the solution, facing downwards, away from the bottom of the bottle. The bottle is sealed and placed into a water bath of a growth temperature range of 60 to 85 °C for 30 min to 3 h depending on the length of the rod requirement. After the growth, the substrate was removed from the bottle.

### Deposition of the planarising layer

The functionalized (organosilane) nanoparticles were first added to a solution mixture of 2-methoxyethanol (2MOE) and PGME (1-methoxy-2-propanal) for dispersion. The ratio of 2MOE to PGME is 1:1 and both components are dispersed uniformly into the acrylic polymer. In one embodiment, the total concentration of nanostructured material in the polymer was kept as 34% by weight of the total polymer with a different ratio of metal and metal oxide nanoparticles, such as between about 10 (metal oxide):1 (metal). The nanoparticles dispersed in the acrylic polymer solution were spin coated onto the plain nanostructured metal compound layer. In one embodiment, the synthesis and fabrication of thin films of planarising layers were under taken in the glove box which has partial pressure (700 mbar) of nitrogen. The oxygen and water vapor contents were controlled with less than 1 ppm level in the glove box. Spin coating under glove box, CVD or plasma polymerization methods, Web Flight Coating method or any other suitable deposition methods can be used to deposit these layers.

### Calcium Degradation Test on multilayer barrier film

The multilayer barrier films are transferred to a vacuum evaporation chamber (thermal evaporation) under vacuum. The multilayer barrier films are then evaluated for their barrier properties using the calcium sensor described in WO 2005/095924. The calcium sensors referred to in WO 2005/095924 allow qualitative evaluation and quantitative evaluation. An example for a calcium sensor that allows qualitative evaluation is illustrated in Figure 4.

In a qualitative evaluation, a test cell as shown in Figure. 4 is formed using the fabricated multilayer barrier films. Briefly, two metal tracks with dimensions of 2 cm by 2 cm are fabricated. A sensing element having dimensions of 1 cm length, 2 cm width and 150 nm thickness is formed in between the two electrodes. The measured resistivity of the sensing element is 0.37Ω-cm. After the deposition process, a load lock system is used to transfer the sample to a glove box under dry nitrogen at atmospheric pressure. After the calcium deposition 303, a 100 nm silver protection layer 301 was deposited for the qualitative analysis in the test cell shown in Figure 4.

The test cell shown in Figure 4 is comprised of a substrate 306 coated with the multilayer barrier film 305 to be tested. As already described, the calcium sensor 303 is coated with a silver layer 301 and arranged in a chamber which is isolated at its side with a UV curable epoxy resin 302 and is sealed off to the top with a glass slide 307. A getter material 308 is attached to the cover glass slide to adsorb any water vapor produced as a result of out gassing or permeation through the epoxy sealing.

To accelerate the permeation tests, the samples were placed into a humidity chamber at constant temperature and humidity of 60°C & 90% relative humidity (RH), respectively. The samples were viewed optically at regular intervals for the qualitative degradation test and analysis of the defects.

The calcium degradation test (CDT) using the calcium test cell structure illustrated in Figure 4 provides visual qualitative information on defects such as pinholes cracks and nano-pores, because the permeated water vapors diffuse through the defects of the substrate and its barrier layer(s) and react with the calcium sensor. Micro-pores and sub-micron sized pores such as pinholes and cracks in a transparent coating are very difficult to discern or to study even by sophisticated surface microscopy techniques (e.g. SEM). In the present experiment, the contrast between oxidized and non-oxidized calcium was used for qualitative analysis. The degradation was monitored using optical microscopy. The images were taken at intervals of typically several hours. From the images the calcium-corroded spots could be directly linked to defects of the barrier films. Further, growth dynamics of the calcium corrosion could provide qualitative information of barrier properties. The images in Figure 5 highlight the nature of the defects exhibited on in A & B films that have been tested and the barrier structure described as before.

The qualitative Calcium Degradation Test (CDT) images of Figure 5 show that the film B has shown significant barrier properties as compared to the conventional barrier stack A. The initial calcium sensor degradation shown with film B at 55 hours and the oxidation growth is very slow. The images of 290 hours of the calcium sensor show that the degradation is not significantly growing. The entire calcium degraded before 570 hours. However, the sensor fabricated onto the conventional barrier structure film A have shown and initial degradation at 5.5 hrs and entire calcium degraded at 22 hours.

Composition of barrier stack B:
Substrate layer: polycarbonate (188 µm thick)
Barrier layer: Al₂O₃ (50 nm thick)
Nanostructured metal compound layer: ZnO₂ (approximately 250 nm to 500 nm thick)
Planarising layer: Al₂O₃ dispersed in acrylic polymer (2 µm thick) (34 wt% Al₂O₃ particles) spherical nanoparticles having a diameter of 20 to 40 nm.
Composition of barrier stack A:
Substrate layer: polycarbonate (188 µm thick)
First barrier layer: ITO (50 nm thick)
Polymeric layer of plane acrylic polymer (2 µm thick)
Second barrier layer: ITO (50 nm thick)

## Claims

1. A multilayer barrier film comprising:
▪ a substrate layer coated on one side with a barrier layer, wherein the barrier layer is made of a material selected from the group consisting of a metal oxide, a metal carbide, a metal nitride and a metal oxynitride;
▪ a nanostructured metal compound layer arranged on the barrier layer; and
▪ a planarising layer arranged on the nanostructured layer, wherein the planarising layer comprises a nanostructured material which is distributed in a polymeric binder, wherein the nanostructured material is made of carbon, or a metal or a metal oxide or a mixture of the aforementioned substances.

2. The multilayer barrier film of claim 1, wherein
1) the nanostructured metal compound is selected from the group consisting of a metal sulfite, a metal phosphate, a metal, a metal nitride, a metal oxynitride and a metal oxide; or
2) the nanostructured metal compound is a nanostructured metal oxide.

3. The multilayer barrier film of claim 1 or 2, wherein the metal of the metal carbide, metal sulfite, metal phosphate, metal, metal nitride, metal oxynitride and metal oxide is independently selected from the group consisting of metals from periodic groups 2 to 14.

4. The multilayer barrier film of claim 3, wherein the metal from the periodic groups 2 to 14 is selected from the group consisting of aluminium, gallium, indium, indium-doped tin, thallium, titanium, zirconium, hafnium, molybdenum, chromium, tungsten, zinc, silicon, germanium, tin, barium, strontium, calcium, magnesium, manganese, tantalum, yttrium and vanadium and mixtures thereof.

5. The multilayer barrier film of claim 1 or 2, wherein
1) the metal oxide is selected from the group consisting of TiO₂, Al₂O₃, ZrO₂, ZnO, BaO, SrO, CaO and MgO, VO₂, CrO₂, MoO₂, LiMn₂O₄, cadmium stannate (Cd₂SnO₄), cadmium indate (CdIn₂O₄), zinc stannate (Zn₂SnO₄ and ZnSnO₃), zinc indium oxide (Zn₂In₂O₅) and mixtures thereof; or
2) the metal nitride is selected from the group consisting of TiN, AlN, ZrN, Zn₃N₂, Ba₃N₂, Sr₃N₂, Ca₃N₂ and Mg₃N₂, VN, CrN and MoN; or
3) the metal oxynitride is selected from the group consisting of TiOₓN_{y}, AlON, ZrON, Zn₃(N₁₋ₓOₓ)_{2-y}, SrON, VON, CrON, MoON and stoichiometric equivalents thereof.

6. The multilayer barrier film of any one of the preceding claims, wherein
1) the nanostructured metal compound layer is extending into or filling (partially or fully) the defects comprised in the barrier layer; and/or
2) the nanostructure of the nanostructured metal compound layer is selected from the group consisting of a nanowire, a single-crystal nanostructure, a double-crystal nanostructure, a polycrystalline nanostructure and an amorphous nanostructure.

7. The multilayer barrier film of any one of the preceding claims, wherein the nanostructured material comprised in the planarising layer is rod-shaped.

8. The multilayer barrier film of claim 7, wherein the rod-shape has a diameter of between 10 nm to 50 nm, a length of 50 to 400 nm, and an aspect ratio of 5 or more.

9. The multilayer barrier film of any one of the preceding claims, wherein
1) the nanostructured material of the planarising layer has a length of less than 200 nm; and/or
2) the nanostructured material of the planarising layer has a surface area to weight ratio of between 1 m²/g to 200 m²/g; and/or
3) the polymeric binder is a material selected from the group consisting of polyacrylate, polymethacrylate, polyacrylamide, polyepoxide, parylene, polysiloxanes and polyurethane; and/or
4) the amount of nanostructured material in the planarising layer is between 0.0000001% to 50% by weight related to the total weight of the monomer of the polymeric binder; and/or
5) the planarising layer further comprises an UV absorbing organic compound, preferably wherein the UV absorbing organic compound is selected from the group consisting of 4-methylbenzylidene camphor, isoamyl p-methoxycinnamate, 2-hydroxyphenyl benzotriazole, 2-hydroxy-benzophenone, 2-hydroxy-phenyltriazine and oxalanilide.

10. The multilayer barrier film of any one of the preceding claims, wherein the substrate is an organic polymer or an inorganic polymer or a mixture thereof.

11. The multilayer barrier film of claim 10, wherein
1) the organic polymer is selected from the group consisting of polyacetate, polypropylene, cellophane, poly(1-trimethylsilyl-1-propyne, poly(ethylene-2,6-naphthalene dicarboxylate) (PEN), poly(ethylene terephthalate) (PET), poly(4-methyl-2-pentyne), polyimide, polycarbonate (PC), polyethylene, polyethersulfone (PES), epoxy resins, polyethylene terephthalate, polystyrene, polyurethane, polyacrylate, polyacrylamide, polydimethylphenylene oxide, styrene-divinylbenzene copolymers, polyolefin, polyvinylidene fluoride (PVDF), nylon, nitrocellulose, cellulose and acetate; or
2) the inorganic polymer is selected from the group consisting of silica (glass), nano-clays, silicones, polydimethylsiloxanes, biscyclopentadienyl iron, indium tin oxide, polyphosphazenes and derivatives thereof; or
3) said polymers are transparent or semi-transparent or opaque.

12. The multilayer barrier film of any one of the preceding claims, wherein
1) the barrier layer, nanostructured metal compound layer and planarising layer are arranged on both sides of the substrate; and/or
2) a further barrier layer is arranged on the planarising layer; and/or
3) the substrate has a thickness of between 1 µm to 3 mm; and/or
4) the barrier layer has a thickness of between 5 nm to 500 nm; and/or
5) the nanostructured metal compound layer has a thickness of between 200 nm to 10 µm; and/or
6) the planarising layer has a thickness of between 200 nm to 1 µm.

13. A method of manufacturing a multilayer barrier film according to any one of the preceding claims, wherein the method comprises:
▪ providing a barrier layer coated substrate;
▪ applying a solution of a metal particle precursor dissolved in an organic solvent on the barrier layer to obtain a seed layer;
▪ growing metal nanocrystals via a solvent thermal method to obtain a nanostructured metal compound layer;
▪ depositing a planarising layer on the nanostructured metal compound layer.

14. The method of claim 13, wherein the seed layer can be applied by any of the methods selected from the group consisting of spin coating, imprinting methods, such as ink jet printing or screen printing; and roll to roll coating methods, such as tip coating or slot die coating.

## Patentansprüche

1. Ein vielschichtiger Barrierefilm, umfassend:
▪ eine Substratschicht, die auf einer Seite mit einer Barriereschicht beschichtet ist, wobei die Barriereschicht aus einem Material ausgewählt aus der Gruppe bestehend aus einem Metalloxid, einem Metallcarbid, einem Metallnitrid und einem Metalloxynitrid besteht;
▪ eine nanostrukturierte Metallverbindungsschicht, die auf der Barriereschicht angeordnet ist; und
▪ eine planarisierende Schicht, die auf der nanostrukturierten Schicht angeordnet ist, wobei die planarisierende Schicht ein nanostrukturiertes Material umfasst, das in einem polymeren Bindemittel verteilt ist, wobei das nanostrukturierte Material aus Kohlenstoff oder einem Metall oder einem Metalloxid oder einer Mischung der vorgenannten Substanzen besteht.

2. Der vielschichtige Barrierefilm gemäß Anspruch 1, wobei
1) die nanostrukturierte Metallverbindung ausgewählt ist aus der Gruppe bestehend aus einem Metallsulfit, einem Metallphosphat, einem Metall, einem Metallnitrid, einem Metalloxynitrid und einem Metalloxid; oder
2) die nanostrukturierte Metallverbindung ein nanostrukturiertes Metalloxid ist.

3. Der vielschichtige Barrierefilm gemäß Anspruch 1 oder 2, wobei das Metall des Metallcarbids, Metallsulfits, Metallphosphats, Metalls, Metallnitrids, Metalloxynitrids und Metalloxids unabhängig ausgewählt ist aus der Gruppe bestehend aus Metallen der Periodengruppen 2 bis 14.

4. Der vielschichtige Barrierefilm gemäß Anspruch 3, wobei das Metall aus den Periodengruppen 2 bis 14 ausgewählt ist aus der Gruppe bestehend aus Aluminium, Gallium, Indium, Indium-dotiertem Zinn, Thallium, Titan, Zirkonium, Hafnium, Molybdän, Chrom, Wolfram, Zink, Silizium, Germanium, Zinn, Barium, Strontium, Calcium, Magnesium, Mangan, Tantal, Yttrium und Vanadium und Mischungen davon.

5. Der vielschichtige Barrierefilm gemäß Anspruch 1 oder 2, wobei
1) das Metalloxid ausgewählt ist aus der Gruppe bestehend aus TiO₂, Al₂O₃, ZrO₂, ZnO, BaO, SrO, CaO und MgO, VO₂, CrO₂, MoO₂, LiMn₂O₄, Cadmiumstannat (Cd₂SnO₄), Cadmiumindat (CdIn₂O₄), Zinkstannat (Zn₂SnO₄ und ZnSnO₃), Zinkindiumoxid (Zn₂In₂O₅) und Mischungen davon; oder
2) das Metallnitrid ausgewählt ist aus der Gruppe bestehend aus TiN, AlN, ZrN, Zn₃N₂, Ba₃N₂, Sr₃N₂, Ca₃N₂ und Mg₃N₂, VN, CrN und MoN; oder
3) das Metallixynitrid ausgewählt ist aus der Gruppe bestehend aus TiOₓN_{y}, AlON, ZrON, Zn₃(N₁₋ₓOₓ)_{2-y}, SrON, VON, CrON, MoON und stöchiometrischen Äquivalenten davon.

6. Der vielschichtige Barrierefilm gemäß einem der voranstehenden Ansprüche, wobei
1) die nanostrukturierte Metallverbindungsschicht bis in Defekte hineinreicht oder diese ausfüllt (teilweise oder vollständig), die in der Barriereschicht enthalten sind; und/oder
2) die Nanostruktur der nanostrukturierten Metallverbindungsschicht ausgewählt ist aus der Gruppe bestehend aus einem Nanodraht, einer Einkristall-Nanostruktur, einer Doppelkristall-Nanostruktur, einer polykristallinen Nanostruktur und einer amorphen Nanostruktur.

7. Der vielschichtige Barrierefilm gemäß einem der voranstehenden Ansprüche, wobei das nanostrukturierte Material, das in der planarisierenden Schicht enthalten ist, stabförmig ist.

8. Der vielschichte Barrierefilm gemäß Anspruch 7, wobei die Stabform einen Durchmesser von zwischen 10 nm bis 50 nm, eine Länge von 50 bis 400 nm und ein Seitenverhältnis von 5 oder mehr hat.

9. Der vielschichte Barrierefilm gemäß einem der voranstehenden Ansprüche, wobei
1) das nanostrukturierte Material der planarisierenden Schicht eine Länge von weniger als 200 nm hat; und/oder
2) das nanostrukturierte Material der planarisierenden Schicht ein Oberflächen-Gewichts-Verhältnis von zwischen 1 m²/g bis 200 m²/g hat; und/oder
3) das polymere Bindemittel ein Material ausgewählt aus der Gruppe bestehend aus Polyacrylat, Polymethacrylat, Polyacrylamid, Polyepoxid, Parylen, Polysiloxanen und Polyurethan ist; und/oder
4) die Menge an nanostrukturiertem Material in der planarisierenden Schicht zwischen 0,0000001 Gew.-% bis 50 Gew.-% ist, bezogen auf das Gesamtgewicht des Monomers des polymeren Bindemittels; und/oder
5) die planarisierende Schicht des Weiteren eine UV-absorbierende organische Verbindung umfasst, wobei, vorzugsweise, die UV-absorbierende organische Verbindung ausgewählt ist aus der Gruppe bestehend aus 4-Methylbenzylidencampher, 4-Methoxyzimtsäureisoamylester, 2-Hydroxyphenylbenzotriazol, 2-Hydroxybenzophenon, 2-Hydroxyphenlytriazin und Oxalanilid.

10. Der vielschichte Barrierefilm gemäß einem der voranstehenden Ansprüche, wobei das Substrat ein organisches Polymer oder ein anorganisches Polymer oder eine Mischung davon ist.

11. Der vielschichtige Barrierefilm gemäß Anspruch 10, wobei
1) das organische Polymer ausgewählt ist aus der Gruppe bestehend aus Polyacetat, Polypropylen, Cellophan, Poly(1-trimethylsilyl-1-propin), Poly(ethylen-2,6-naphthalindicarboxylat) (PEN), Poly(ethylenterephthalat) (PET), Poly(4-methyl-2-pentin), Polyimid, Polycarbonat (PC), Polyethylen, Polyethersulfon (PES), Epoxyharzen, Polyethylenterephthalat, Polystyrol, Polyurethan, Polyacrylat, Polyacrylamid, Polydimethylphenylenoxid, Styrol-Divinylbenzol-Copolymeren, Polyolefin, Polyvinylidenfluorid (PVDF), Nylon, Nitrocellulose, Cellulose und Acetat; oder
2) das anorganische Polymer ausgewählt ist aus der Gruppe bestehend aus Siliziumdioxid (Glas), Nano-Tonen, Silikonen, Polydimethylsiloxanen, Bis(cyclopentadienyl)eisen, Indiumzinnoxid, Polyphosphazenen und Derivaten davon; oder
3) die Polymere transparent oder semi-transparent oder opak sind.

12. Der vielschichtige Barrierefilm gemäß einem der voranstehenden Ansprüche, wobei
1) die Barriereschicht, die nanostrukturierte Metallverbindungsschicht und die planarisierende Schicht auf beiden Seiten des Substrats angeordnet sind; und/oder
2) eine weitere Barriereschicht auf der planarisierenden Schicht angeordnet ist; und/oder
3) das Substrat eine Dicke von zwischen 1 µm bis 3 mm hat; und/oder
4) die Barriereschicht eine Dicke von zwischen 5 nm bis 500 nm hat; und/oder
5) die nanostrukturierte Metallverbindungsschicht eine Dicke von zwischen 200 nm bis 10 µm hat; und/oder
6) die planarisierende Schicht eine Dicke von zwischen 200 nm bis 1 µm hat.

13. Ein Verfahren zur Herstellung eines vielschichtigen Barrierefilms gemäß einem der voranstehenden Ansprüche, wobei das Verfahren umfasst:
▪ Bereitstellen eines mit einer Barrierschicht beschichteten Substrats;
▪ Auftragen einer Lösung einer Metallpartikelvorstufe, die in einem organischen Lösemittel gelöst ist, auf die Barriereschicht, um eine Nukleationsschicht zu erhalten;
▪ Wachsen-lassen von Metallnanokristallen mittels eines Thermal-Lösemittelverfahrens, um eine nanostrukturierte Metallverbindungsschicht zu erhalten;
▪ Abscheiden einer planarisierenden Schicht auf der nanostrukturierten Metallverbindungsschicht.

14. Das Verfahren gemäß Anspruch 13, wobei die Nukleationsschicht mittels eines der Verfahren ausgewählt aus der Gruppe bestehend aus Reaktionsbeschichtung, Druckverfahren wie Tintenstrahldrucken oder Siebdruck; und Rolle-zu-Rolle-Beschichtungsverfahren wie Spitzenbeschichtung oder Düsenbeschichtung aufgetragen werden kann.

## Revendications

1. Film de barrière multicouche comprenant :
• une couche de substrat revêtue sur un côté par une couche de barrière, la couche de barrière étant faite en un matériau choisi dans l'ensemble constitué par un oxyde métallique, un carbure métallique, un nitrure métallique et un oxynitrure métallique ;
• une couche de composé métallique nanostructuré disposée sur la couche de barrière ; et
• une couche de planarisation disposée sur la couche nanostructurée, la couche de planarisation comprenant un matériau nanostructuré qui est distribué dans un liant polymère, le matériau nanostructuré étant fait de carbone, ou d'un métal ou d'un oxyde métallique ou d'un mélange des substances susmentionnées.

2. Film de barrière multicouche selon la revendication 1, dans lequel
1) le composé métallique nanostructuré est choisi dans l'ensemble constitué par un sulfite métallique, un phosphate métallique, un métal, un nitrure métallique, un oxynitrure métallique et un oxyde métallique ; ou
2) le composé métallique nanostructuré est un oxyde métallique nanostructuré.

3. Film de barrière multicouche selon la revendication 1 ou 2, dans lequel le métal du carbure métallique, sulfite métallique, phosphate métallique, métal, nitrure métallique, oxynitrure métallique et oxyde métallique est indépendamment choisi dans l'ensemble constitué par les métaux des Groupes 2 à 14 du Tableau périodique.

4. Film de barrière multicouche selon la revendication 3, dans lequel le métal des Groupes 2 à 14 du Tableau Périodique est choisi dans l'ensemble constitué par l'aluminium, le gallium, l'indium, l'étain dopé à l'indium, le thallium, le titane, le zirconium, le hafnium, le molybdène, le chrome, le tungstène, le zinc, le silicium, le germanium, l'étain, le baryum, le strontium, le calcium, le magnésium, le manganèse, le tantale, l'yttrium et le vanadium, ainsi que leurs mélanges.

5. Film de barrière multicouche selon la revendication 1 ou 2, dans lequel
1) l'oxyde métallique est choisi dans l'ensemble constitué par TiO₂, Al₂O₃, ZrO₂, ZnO, BaO, SrO, CaO et MgO, VO₂, CrO₂, MoO₂, LiMn₂O₄, le stannate de cadmium (Cd₂SnO₄), l'indate de cadmium (CdIn₂O₄), le stannate de zinc (Zn₂SnO₄ et ZnSnO₃), l'oxyde d'indium et de zinc (Zn₂In₂O₅), et leurs mélanges ; ou
2) le nitrure métallique est choisi dans l'ensemble constitué par TiN, AlN, ZrN, Zn₃N₂, Ba₃N₂, Sr₃N₂, Ca₃N₂ et Mg₃N₂, VN, CrN et MoN ; ou
3) l'oxynitrure métallique est choisi dans l'ensemble constitué par TiOₓN_{y}, AlON, ZrON, Zn₃(N₁₋ₓOₓ)_{2-y}, SrON, VON, CrON, MoON et leurs équivalents stoechiométriques.

6. Film de barrière multicouche selon l'une quelconque des revendications précédentes, dans lequel
1) la couche de composé métallique nanostructuré s'étend dans ou remplit (partiellement ou complètement) les défauts compris dans la couche de barrière ; et/ou
2) la nanostructure de la couche de composé métallique nanostructuré est choisie dans l'ensemble constitué par un nanofil, une nanostructure monocristalline, une nanostructure bicristalline, une nanostructure polycristalline et une nanostructure amorphe.

7. Film de barrière multicouche selon l'une quelconque des revendications précédentes, dans lequel le matériau nanostructuré compris dans la couche de planarisation est en forme de bâtonnets.

8. Film de barrière multicouche selon la revendication 7, dans lequel la forme de bâtonnets a un diamètre compris entre 10 nm et 50 nm, une longueur de 50 à 400 nm, et un rapport d'aspect de 5 ou plus.

9. Film de barrière multicouche selon l'une quelconque des revendications précédentes, dans lequel
1) le matériau nanostructuré de la couche de planarisation a une longueur inférieure à 200 nm ; et/ou
2) le matériau nanostructuré de la couche de planarisation a un rapport de la superficie au poids compris entre 1 m²/g à 200 m²/g ; et/ou
3) le liant polymère est un matériau choisi dans l'ensemble constitué par le polyacrylate, le polyméthacrylate, le polyacrylamide, le polyépoxyde, le parylène, les polysiloxanes et le polyuréthane ; et/ou
4) la quantité de matériau nanostructuré dans la couche de planarisation est comprise entre 0,0000001 % et 50 % en poids par rapport au poids total du monomère du liant polymère ; et/ou
5) la couche de planarisation comprend en outre un composé organique absorbant les UV, le composé organique absorbant les UV étant de préférence choisi dans l'ensemble constitué par le 4-méthylbenzylidène-camphre, le p-méthoxycinnamate d'isoamyle, le 2-hydroxyphényl-benzotriazole, la 2-hydroxy-benzophénone, la 2-hydroxy-phényltriazine et l'oxalanilide.

10. Film de barrière multicouche selon l'une quelconque des revendications précédentes, dans lequel le substrat est un polymère organique ou un polymère inorganique ou un mélange de ceux-ci.

11. Film de barrière multicouche selon la revendication 10, dans lequel
1) le polymère organique est choisi dans le groupe constitué par le polyacétate, le polypropylène, le cellophane, le poly(1-triméthylsilyl-1-propyne), le poly(dicarboxylate d'éthylène-2,6-naphtalène) (PEN), le poly(téréphtalate d'éthylène) (PET), le poly(4-méthyl-2-pentyne), le polyimide, le polycarbonate (PC), le polyéthylène, la polyéthersulfone (PES), les résines époxy, le poly(téréphtalate d'éthylène), le polystyrène, le polyuréthane, le polyacrylate, le polyacrylamide, le poly(oxyde de diméthylphénylène), les copolymères de styrène-divinylbenzène, la polyoléfine, le poly(fluorure de vinylidène) (PVDF), le nylon, la nitrocellulose, la cellulose et l'acétate ; ou
2) le polymère inorganique est choisi dans l'ensemble constitué par la silice (verre), les nano-argiles, les silicones, les polydiméthylsiloxanes, le biscyclopentadiényl-fer, l'oxyde d'indium et d'étain, les polyphosphazènes et leurs dérivés ; ou
3) lesdits polymères sont transparents ou semi-transparents ou opaques.

12. Film de barrière multicouche selon l'une quelconque des revendications précédentes, dans lequel
1) la couche de barrière, la couche de composé métallique nanostructuré et la couche de planarisation sont disposées sur les deux côtés du substrat ; et/ou
2) une autre couche de barrière est disposée sur la couche de planarisation ; et/ou
3) le substrat a une épaisseur comprise entre 1 µm et 3 mm ; et/ou
4) la couche de barrière a une épaisseur comprise entre 5 nm et 500 nm ; et/ou
5) la couche de composé métallique nanostructuré a une épaisseur comprise entre 200 nm et 10 µm ; et/ou
6) la couche de planarisation a une épaisseur comprise entre 200 nm et 1 µm.

13. Procédé de fabrication d'un film de barrière multicouche selon l'une quelconque des revendications précédentes, lequel procédé comprend les opérations consistant à :
• disposer d'un substrat revêtu de couche de barrière ;
• appliquer une solution d'un précurseur particulaire métallique dissous dans un solvant organique sur la couche de barrière pour obtenir une couche d'ensemencement ;
• faire croître des nanocristaux métalliques via un procédé thermique au solvant pour obtenir une couche de composé métallique nanostructuré ;
• déposer une couche de planarisation sur la couche de composé métallique nanostructuré.

14. Procédé selon la revendication 13, dans lequel la couche d'ensemencement peut être appliquée par l'un quelconque des procédés choisis dans l'ensemble constitué par un revêtement centrifuge, des procédés d'impression, tels qu'une impression par jet d'encre ou une sérigraphie ; et des procédés d'impression rouleau à rouleau, tels qu'un revêtement à pointe ou un revêtement à filière plate.
